# EUROPEAN PATENT APPLICATION

(11) **EP 0 801 313 A2**
(43) Date of publication of application: **15.10.1997**
(21) Application number: 97250108.4
(22) Date of filing: 09.04.1997
(51) Int. Cl.: G01R 33/09

(54) **Integrated magnetic sensor and method for manufacturing the same**

(30) Priority: 10.04.1996 JP 86960/96
(71) Applicant: NEC CORPORATION, Tokyo (JP)
(72) Inventor: Konno, Hideto, Minato-ku, Tokyo (JP)
(74) Representative: Patentanwälte Wenzel & Kalkoff

(57) **Abstract**

In the magneto-resistance effect device of the present invention, use is made of Ni₈₂Fe₁₂Co₆ film as the magneto-resistance devices (11 to 14). By detecting an outer magnetic field at a bridge circuit composed of the four magneto-resistance devices (11 to 14), the resistance value of the magneto-resistance devices (11 to 14) varies to cause variation of the midpoint potential, and the consequent potential difference then is input into comparator circuit 5,200 to output a pulse. At a low magnetic field (at 1 to 2 mT), Ni₈₂Fe₁₂ Co₆ has a rate of magneto-resistance change as large as 2 to 2.5-fold that of a binary alloy NiFe as well as a positive magnetostriction constant of +1.8 x 10⁻⁶, under less influence of substrate distortion or stress from the upper layer.

## Description

### BACKGROUND OF THE INVENTION

The present invention relates to an integrated magnetic sensor and a method for manufacturing the same. More specifically, the present invention relates to an integrated magnetic sensor having been integrated and formed on a semiconductor circuit substrate.

Conventionally known magnetic sensors include a magnetic sensor described in Japanese Patent Laid-open No. Hei 2-195284. The publication describes a magnetic sensor composed of a film comprising Ni at 81.1 to 81.8 % by weight (abbreviated as wt % 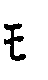 hereinafter) and the remaining part of Fe along with unavoidable impurities as the magneto-sensitive device.

As described in the reference IEEE. TRANS. MAG. Vol. MAG-II, No.4, July, 1975 , page 1019, the peak of the rate of resistance change which is most significant for magneto-resistance device positions is not in a range of 81.1 to 81.8 wt % of Ni but in a range of 85 to 90 wt % of Ni. Thus, the characteristic properties of the magneto-resistance device described in the publication cannot most efficiently be utilized.

For integrating a magnetic sensor with a semiconductor circuit, the design margin and manufacturing margin can be more widely set up as the magnetic field-sensitive performance of the magneto-resistance device is better. For the integration, further, a protective film should be mounted on the magneto-resistance device fabricated from a ferromagnetic film. Such protective film is generally formed by CVD (abbreviation of chemical vapor deposition).

When intending to form the protective film by CVD, tensile stress occurs during the formation, which disadvantageously reduces output due to the reverse magnetostriction effect.

The magnetic sensor described in the publication is not integrated together with the semiconductor circuit, so no such protective film is mounted on the sensor. Thus, no tensile stress due to CVD is taken into account.

### SUMMARY OF THE INVENTION

It is an object of the present invention to overcome the drawbacks described above and to provide an integrated magnetic sensor with a larger rate of magneto-resistance change and with no output reduction even if tensile stress develops due to CVD; and a method for manufacturing the magnetic sensor.

The integrated magnetic sensor of the present invention includes a magneto-resistance device fabricated from a ferromagnetic film and for detecting the direction of a magnetic field, and a protective film formed by CVD and for protecting the ferromagnetic film. In the ferromagnetic film, the Ni composition ratio is at 82 wt %; the Fe composition ratio is at 10 to 12 wt %. Additionally, the Co composition ratio is at 6 to 8 wt %.

The method for manufacturing an integrated magnetic sensor in accordance with the present invention includes a process of manufacturing a ferromagnetic film at the Ni composition ratio at 82 wt %, the Fe composition ratio at 10 to 12 wt %, and the Co composition ratio at 6 to 8 wt %. The protective film for protecting the ferromagnetic film is formed by CVD.

For the integrated magnetic sensor, Ni₈₂Fe₁₂Co₆ film is used as the magneto-resistance device for practical output in response to an outer magnetic field. Four such devices are used to construct a bridge circuit to detect an outer magnetic field. On detection of the outer magnetic field, the resistance value of the magneto-resistance devices varies to cause variation of the midpoint potential, and the consequent potential difference then is input into a comparator circuit to output a pulse.

At a low magnetic field (at 1 to 2 mT), Ni₈₂Fe₁₂ Co₆ has a rate of magneto-resistance change as large as 2 to 2.5-fold that of a binary alloy NiFe as well as a positive magnetostriction constant of +1.8 x 10⁻⁶, under less influence of substrate distortion or stress from the upper layer. The adverse effects of stress at a negative magnetostriction constant are as described in the Japanese Patent Laid-open No. Hei 2-19528.

### BRIEF DESCRIPTION OF THE DRAWINGS

The above and other objects, features and advantages of the present invention will become apparent from the following detailed description when taken with the accompanying drawings.
Fig. 1 is a view of an equivalent circuit, depicting the integrated magnetic sensor of an example in accordance with the present invention;
Fig. 2 is a perspective view depicting the integrated magnetic sensor of the example in accordance with the present invention, which is at a state after mold sealing;
Fig. 3 is a cross-sectional view depicting a part connecting a magneto-resistance device part with a semiconductor circuit part;
Fig. 4 shows graphs depicting the characteristics of the rate of magneto-resistance change regarding the binary alloy NiFe and the tertiary alloy Ni₈₂Fe₁₂ Co₆ vs. magnetic field;
Fig. 5 shows a view depicting the characteristics of the rate of magneto-resistance change regarding the binary alloy NiFe and the tertiary alloy Ni₈₂Fe₁₂ Co₆ vs. line width;
Fig. 6A depicts the bridge output voltage characteristics of Ni₈₅Fe₁₅ vs. alternating field applied;
Fig. 6B depicts the bridge output voltage characteristics of Ni₈₂Fe₁₂Co₆ vs. alternating field applied;
Fig. 7 is a view depicting the relation between the composition ratio of NiFeCo film and the magnetic characteristics; and
Fig. 8 is a view depicting the relation between the composition ratio of the binary alloy NiFe and the rate of magneto-resistance change.

In the drawings, identical references denote identical structural elements.

### DETAILED DESCRIPTION OF THE PREFERRED EMBODIMENT

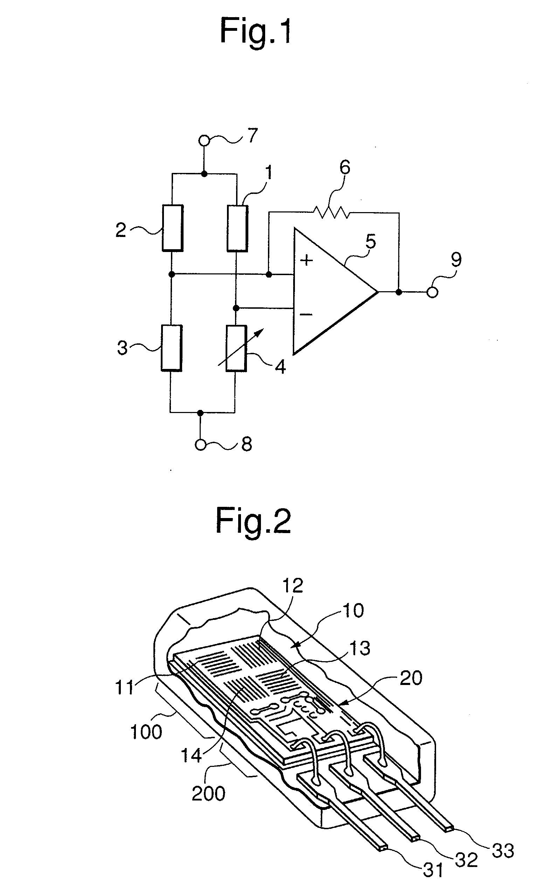

Fig. 1 is a circuit view of an equivalent circuit of the integrated magnetic sensor of the present invention. In the figure, magneto-resistance devices 1 to 4 are fabricated by preparing a ferromagnetic film Ni₈₂Fe₁₂Co₆ into a film of a thickness of 300 to 400 angstrom by vacuum deposition and manufacturing the film into a desired shape through processes including photolithography and etching. The four magneto-resistance devices 1 to 4 construct a bridge circuit, and its output is input into comparator circuit 5 (comparator). Herein, 6 represents feedback resistance; 7 represents power terminal; 8 represents ground terminal; and 9 represents output terminal.

More specifically, the magneto-resistance devices 1 to 4 formed from a ferromagnetic film detect the direction of magnetic field, and these devices 1 to 4 are connected together to the bridge circuit. Two outputs from the facing connections of the bridge circuit are compared with each other in the comparator circuit 5. The resistance value of the magneto-resistance device 4 is different from the resistance of each of the remaining magneto-resistance devices 1 to 3, so that the initial operation can thereby be stabilized.

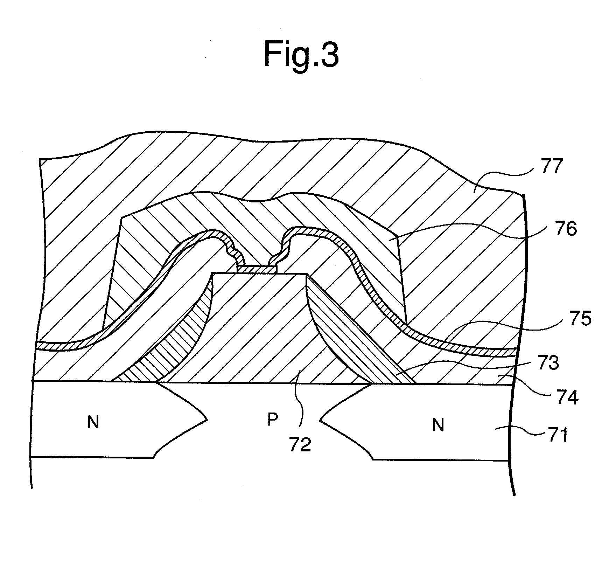

The comparator circuit 5 is preliminarily formed in the Si substrate through a bipolar or metal oxide semiconductor (abbreviated as MOS hereinbelow) process, and as shown for example through the through-hole in Fig. 3, the circuit 5 is electrically connected to magneto-resistance device film 75. In Fig. 3, Au or Al film of a thickness of 1.5 to 2.0 µ m is used as conductor layer 76. By vacuum deposition, the film is formed together with the magneto-resistance device film 75.

Fig. 2 is a perspective view depicting integrated chip 20 after completion of the formation of these films, which is mounted on a lead frame for electrical connection by wire bonding and the like and is then put at a mold-sealed state, wherein mold 10 is partially notched.

In the figure, terminal 31 as a terminal of power Vcc is connected to power terminal 7 in Fig. 1. Terminal 32 as a ground terminal is connected to ground terminal 8 in Fig. 1. Terminal 33 as an output terminal is connected to output terminal 9.

Integrated chip 20 is composed of magneto-resistance device part 100 and comparator circuit part 200.

Magneto-resistance arrays 11 to 14 in the magneto-resistance device part 100 correspond to the magneto-resistance devices 1 to 4 in Fig. 1, and these arrays are in arrangement such that the adjacent devices might have different maximum detection directions from each other. These magneto-resistance arrays 11 to 14 are connected together to compose a bridge circuit, and two outputs from the facing connections are input into the comparator circuit part 200, where the outcome of the comparison is output from output terminal 33.

Fig. 3 is a cross-sectional view depicting a part connecting the magneto-resistance device part with the semiconductor circuit part. In the figure, magneto-resistance device film 75 formed at a thickness of 300 to 400 angstrom (0.03 to 0.04 µ m) is fabricated into a shape with a line width of 10 to 20 µ m.

So as to protect the magneto-resistance device film 75, furthermore, passivation film 77 is arranged on the film 75. The passivation film 77 is composed of SiO₂ at a thickness of 0.5 to 2 µ m, which has been manufactured by ambient-pressure chemical vacuum deposition (abbreviated as CVD below). The CVD is not necessarily limited to ambient-pressure CVD; other CVDs for example plasma CVD may also be applicable to film formation.

To prevent the occurrence of slipping due to the thickness of the underlying Al electrode 72, conductor layer 76 is formed at a thickness about 1.3 fold that of the Al electrode 72. As the conductor layer, Au film of a film thickness of 1.5 to 2.0 µ m is used.

In the figure, 71 is a dispersion layer; 74 is an insulation layer; and 73 is SOG (abbreviation of spin on glass) part.

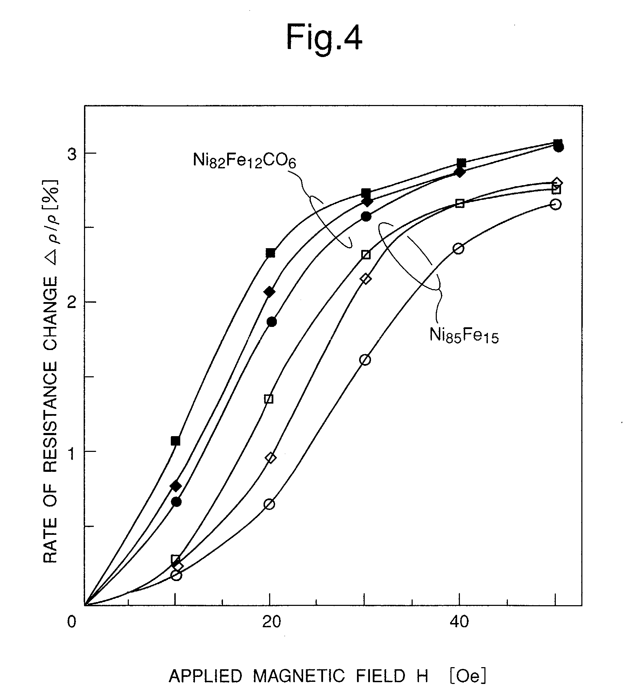

Fig. 4 is a view depicting the characteristics of the rate of the resistance change of a single device of the magneto-resistance device film part vs. applied magnetic field. In the figure, the characteristics of a representative material Ni₈₅Fe₁₅ conventionally used and the characteristics of Ni₈₂Fe₁₂Co₆ used in the present example are comparatively shown together, by using the line width of each of the device pattern as the parameter.

The axis of abscissa represents applied magnetic field H in Oe; the axis of ordinate represents rate of resistance change as Δρ/ρ . In the figure, the symbols ■ and □represent the line width of 16 µ m; the symbols ◆ and 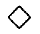 represent the line width of 14 µ m; and ● and ○ represent the line width of 12 µ m.

As shown in the figure, the rate of the resistance change of the tertiary alloy Ni₈₂Fe₁₂Co₆ is far above the rate of the resistance change of the binary alloy Ni₈₅Fe₁₅, irrespective of the level of the outer magnetic field. In a low magnetic field region at an applied magnetic field H of 10 to 20 Oe in particular, the tendency is distinct. As will be described below, the film of a composition Ni₈₅Fe₁₅ has the highest rate of resistance change among the binary NiFe alloy films. Compared with the rate of the film with a composition ratio of 81.1 to 81.8 wt % of Ni and the remaining Fe, the film has a far larger rate of resistance change.

In other words, the characteristic profile as the rate of the magneto-resistance change of the tertiary alloy film Ni₈₂Fe₁₂Co₆ used in the present example is superior to the highest rate of the resistance change of the binary alloy film. As shown in the figure, therefore, a circuit composed of a device of the Ni₈₂Fe₁₂Co₆ alloy can be applied to a lower magnetic field, compared with the NiFe alloy. Additionally because the magnetostriction constant is positive at a smaller absolute value, the magnetic hysteresis is reduced under less influence of outer stress.

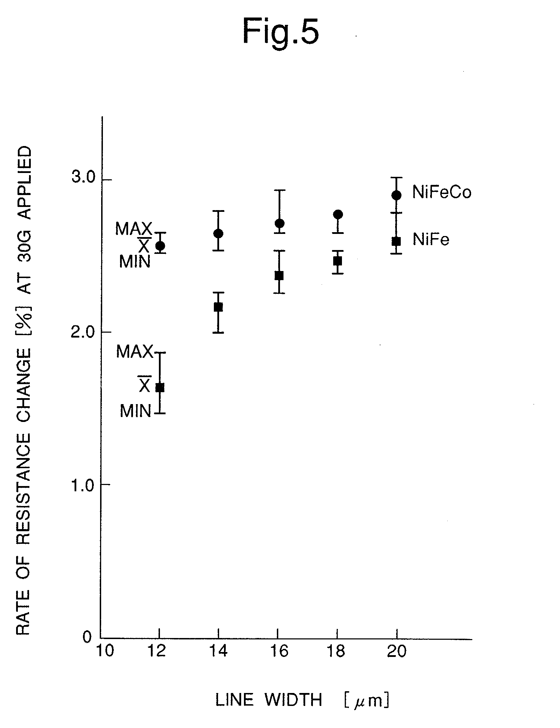

Fig. 5 is another view of the Fig. 4 data vs. line width on the axis of abscissa. In the figure, the axis of ordinate represents the rate of resistance change in % at 30 G applied; the axis of abscissa represents the line width in µ m. With reference to the figure, the maximum and minimum rates of resistance change (abbreviated as MAX and MIN, respectively, below) are shown regarding Ni₈₂Fe₁₂Co₆ and Ni₈₅Fe₁₅, at variable line widths of 12, 14, 16, 18 and 20 µ m. In addition to MAX and MIN, the mean value represented by X is shown as the symbol ● and ■ for Ni₈₂Fe₁₂Co₆ and Ni₈₅Fe₁₅, respectively.

As shown in the figure, the rate of the resistance change of the Ni₈₂Fe₁₂Co₆ used in the present invention is larger than the rate of the binary alloy Ni₈₅Fe_{15.}

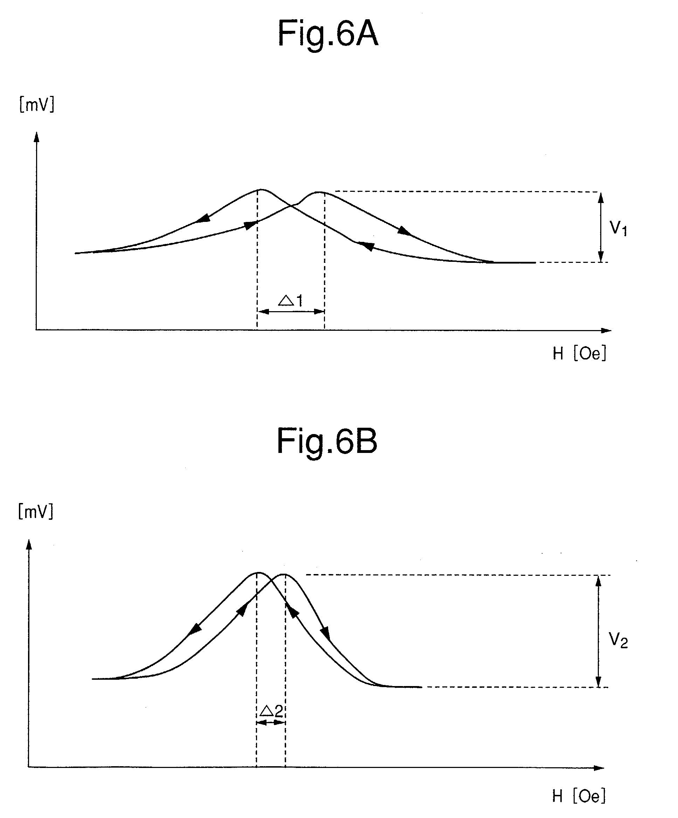

When a conventional material, for example Permalloy Ni₈₅Fe₁₅ film, is used as shown in Fig. 6A, the output profile of a single device thereof vs. an applied magnetic field is significantly influenced by magnetostriction. This leads to a drawback such that a switch sensor detecting the presence or absence of magnetic field has a larger hysteresis Δ1 of the magneto-sensitive field. As described in the aforementioned publication, the sensor is readily influenced by stress due to the warp of the base material.

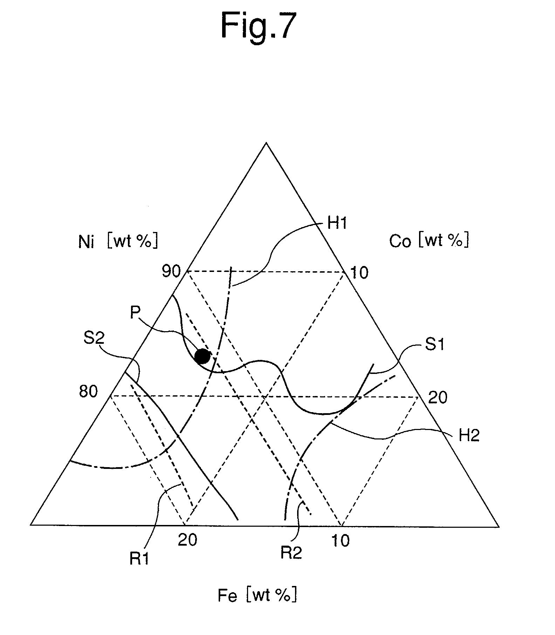

On contrast, the tertiary alloy Ni₈₂Fe₁₂Co₆ used in the present example has a positive magnetostriction value, which will be described now with reference to Fig. 7. In the figure, the relation between the composition ratios of NiFeCo films and their magnetic characteristics is shown. The point P shown in the figure represents Ni₈₂Fe₁₂Co_{6.} In the triangle shown in the figure, the point P occupies a position where Ni is at 82 wt %; Fe is at 12 wt %; and Co is at 6 wt %. In the figure, curves S1 and S2 show positions with a magnetostriction constant λ 0 of zero. The point P exists above the curve S1 in the figure (toward the direction of a larger Ni composition ratio). The point P, namely Ni₈₂Fe₁₂Co₆, has a positive magnetostriction value. Specifically, the value of the magnetostriction constant is +1.8 x 10⁻⁶.

In the figure, R1 is a line with the rate of resistance change Δρ/ρ of Ni₈₂Fe₁₂Co₆ at 2 %; R2 is a line with the rate of resistance change Δρ/ρ at 3 %; H1 is a line of a magnetic field H at 10 Oe; and H2 is a line of a magnetic field H at 200 Oe.

As has been described above, the tertiary alloy Ni₈₂Fe₁₂Co₆ used in the present example has a positive magnetostriction value of +1.8 x 10⁻⁶, so the alloy is hardly influenced by the stress so that the alloy can realize stable magneto-resistance profile, advantageously. As shown in Fig. 6B, more specifically, the integrated magnetic sensor using the tertiary alloy Ni₈₂Fe₁₂Co₆ in accordance with the present invention has a larger rate of resistance change than that of the conventional NiFe binary alloys. Thus, the output voltage value V1 increases in response to the difference in the rate of resistance change, compared with the output voltage V2 of a conventional device (Fig. 6A). Furthermore, the magnetostriction constant is positive with a smaller absolute value, so that the distortion of the wave form and hysteresis Δ2 due to magnetostriction are reduced as shown in the Fig. 6B. Therefore, the design margin and manufacturing margin in allowance of the deviation in initial offset voltage or the value of the rate of the magneto-resistance change of itself can be more widely set up.

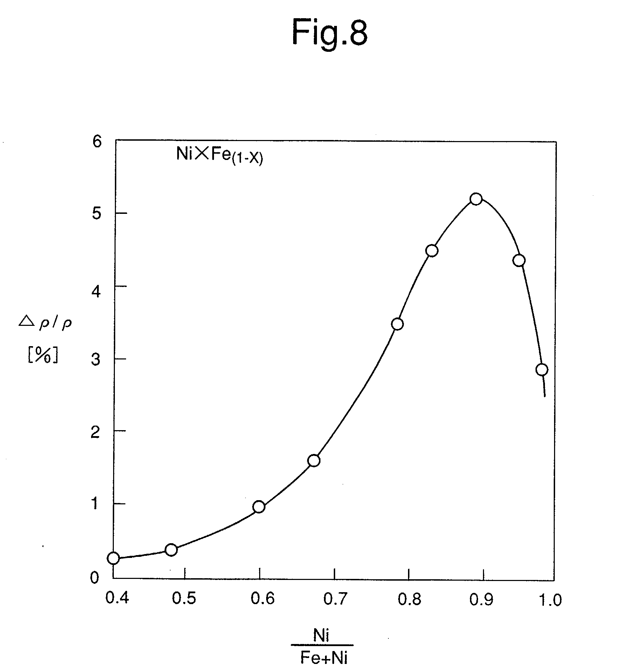

Fig. 8 is a view depicting the relation between the composition ratio of the binary alloy NiFe conventionally used and the rate of the magneto-resistance change thereof. More specifically, the axis of ordinate represents the rate of the magneto-resistance change *Δρ/ρ ;* and the axis of abscissa represents the composition ratio as Ni/(Fe + Ni) in the alloy NiFe. As shown in the figure, the rate of the magneto-resistance change does not reach the highest in the composition region of 81.1 to 81.8 wt % of Ni and the remaining Fe. Therefore, such composition is not the optimum composition.

Instead of constructing a bridge circuit by using four devices, the aforementioned magneto-resistance device part may be composed of two devices in combination with a current mirror circuit; otherwise, the resistance device part may be constructed by arranging a bipolar or CMOS transistor at a part to serially connect the magneto-resistance devices together. Additionally, the output is an output from the integrated circuit so the output may be in any form of analog or digital output.

In the above example, description has been made about a composition at ratios of 82 wt % Ni, 12 wt % Fe and 6 wt % Co. However, it is apparently indicated that a composition ratio involving a positive magnetostriction constant other than the above composition can reduce the effect of outer stress. More specifically, a composition ratio within a range of 82 wt % Ni, 10 to 12 wt % Fe and 6 to 8 wt % Co is illustrated. It is needless to say that the composition ratio of 82 wt % Ni, 12 wt % Fe and 6 wt % Co can most markedly reduce the outer stress effects.

Because the tertiary alloy Ni₈₂Fe₁₀₋₁₂Co₆₋₈ has a larger rate of magneto-resistance change than that of the binary alloy NiFe, as has been described above, the design margin and manufacturing margin can be widely set up in manufacturing integrated magnetic sensors, with the resultant improvement of the productivity and yield.

While the magnetostriction constant of the binary alloy Ni₈₅Fe₁₅ is -8 x 10⁻⁶, the tertiary alloy Ni₈₂Fe₁₂Co₆ has a positive magnetostriction constant of +1.8 x 10⁻⁶ with a small absolute value. Therefore, the tertiary alloy can effectively reduce the outer stress influence during the use of such integrated magnetic sensor.

As has been described above, by using the Ni₈₂Fe₁₂Co₆ film with a larger rate of magneto-resistance change, a smaller saturation magnetic field and a smaller magnetostriction, in accordance with the present invention, more sensitive and more stable operation can be realized effectively, compared with conventional ones. Because the Ni₈₂Fe₁₂Co₆ film has a positive magnetostriction constant with a smaller absolute value, effectively, the magnetic hysteresis can be reduced and the film is less influenced by outer stress.

## Claims

1. An integrated magnetic sensor including a magneto-resistance device fabricated from a ferromagnetic film and for detecting the direction of a magnetic field, and a protective film formed by CVD and for protecting the ferromagnetic film, wherein the ferromagnetic film is at an Ni composition ratio of 82 wt %, a Fe composition ratio of 10 to 12 wt %, and additionally at a Co composition ratio of 6 to 8 wt %.

2. An integrated magnetic sensor, including magneto-resistance arrays comprising four magneto-resistance devices connected together to compose a bridge circuit, the devices fabricated from a ferromagnetic film and for detecting the direction of a magnetic field being in arrangement such that the adjacent devices might have different maximum detection directions from each other; a comparator circuit for comparing two outputs from the facing connections of the bridge circuit; and a protective film formed by CVD and for protecting the ferromagnetic film, wherein the outcome of the comparison at the comparator circuit is output and wherein the ferromagnetic film is at an Ni composition ratio of 82 wt %, a Fe composition ratio of 10 to 12 wt %, and additionally at a Co composition ratio of 6 to 8 wt %.

3. An integrated magnetic sensor according to claim 1, wherein the principal component of the protective film is SiO₂.

4. A method for manufacturing an integrated magnetic sensor, comprising a process of forming a ferromagnetic film at an Ni composition ratio of 82 wt %, a Fe composition ratio of 10 to 12 wt %, and additionally at a Co composition ratio of 6 to 8 wt %, and a process of forming a protective film for protecting the formed ferromagnetic film by ambient-pressure CVD.

5. A method for manufacturing an integrated magnetic sensor according to claim 4, wherein the principal component of the protective film is SiO₂.

6. A method for manufacturing an integrated magnetic sensor according to claim 1, wherein the ferromagnetic film is at an Ni composition ratio of 82 wt %, a Fe composition ratio of 12 wt %, and additionally at a Co composition ratio of 6 wt %.

7. A method for manufacturing an integrated magnetic sensor according to claim 4, wherein the ferromagnetic film is at an Ni composition ratio of 82 wt %, a Fe composition ratio of 12 wt %, and additionally at a Co composition ratio of 6 %.
